# FASCICULE DE BREVET EUROPEEN

(11) **EP 3 939 935 B1**
(45) Date de publication et mention de la délivrance du brevet: **03.09.2025**
(21) Numéro de dépôt: 21185139.9
(22) Date de dépôt: 12.07.2021
(51) Int. Cl.: B81C 1/00, H01H 1/00, H03H 9/02

(54) **ACTUATEUR ÉLECTROMÉCANIQUE NANOMÉTRIQUE ET SON PROCÉDÉ DE FABRICATION**
NANOMETRISCHES ELEKTROMECHANISCHES STELLGLIED UND SEIN HERSTELLUNGSVERFAHREN
NANOMETRIC ELECTROMECHANICAL ACTUATOR AND MANUFACTURING METHOD THEREOF

(30) Priorité: 16.07.2020 FR 2007485
(43) Date de publication de la demande: 19.01.2022
(73) Titulaire: Commissariat à l'Energie Atomique et aux Energies Alternatives, 75015 Paris (FR)
(72) Inventeur: HUTIN, Louis, 38054 GRENOBLE (FR); USAI, Giulia, 38054 GRENOBLE (FR)
(74) Mandataire: Hautier IP

(56) Documents cités:
- EP-A1- 2 138 452
- WO-A2-02/10063

## Description

### DOMAINE TECHNIQUE

La présente invention concerne le domaine des systèmes électromécaniques nanométriques autrement appelé en anglais NEMS pour Nano Electro-Mechanical Systems. Elle trouve pour application particulièrement avantageuse le domaine des actuateurs électromécaniques activés par une force électrostatique.

### ÉTAT DE LA TECHNIQUE

Il existe de nombreux dispositifs nanométriques conçus pour remplacer dans certaines applications les classiques transistors. En effet, les NEMS présentent de nombreux avantages pour certaines applications techniques telles que les télécommunications par exemple.

Il existe pratiquement autant de procédés que de types et de morphologies de NEMS. En effet, c'est réellement un travail de haute précision qu'il est nécessaire de mettre en œuvre pour réaliser ces dispositifs.

Aussi, on connait par exemple le document « Silicon on nothing MEMS electromechanical resonator, Durand et al., Microsyst Technol 2008, 14 :1027-1033 » qui décrit un actuateur électromécanique comprenant une membrane de silicium épitaxié suspendue à plusieurs de ses extrémités au-dessus d'un substrat de silicium. La distance entre ces deux éléments est alors de 100 nm et est obtenue par la suppression d'une couche intercalaire située entre ces deux éléments et ayant servi pour la croissance de la couche de silicium épitaxiée.

Le procédé utilisé ainsi que le dispositif obtenu présentent de nombreux inconvénients. D'une part le procédé ne permet pas de retirer efficacement la totalité de la couche intercalaire située sous la couche de silicium, et d'autre part l'encombrement de ce dispositif est grand compte tenu du fait que la membrane est maintenue en suspension en plusieurs points. Enfin, la membrane est en silicium épitaxié qui n'est donc pas une couche monocristalline, cela réduisant alors ses performances électromécaniques.

Il est également connu de l'état de la technique le document WO 02/10063 A2 concernant un procédé de fabrication d'un commutateur micro-électromécanique ou d'un capteur tunnel avec une poutre en porte-à-faux et le document EP 2 138 452 A1 concernant un procédé flexible permettant de réaliser des MEMS/NEMS en silicium monocristallin dont on peut contrôler les faibles épaisseurs.

Un objet de la présente invention est donc de proposer un procédé et un dispositif répondant en partie au moins à ces problématiques et apportant une amélioration dans la conception d'actuateur électromécanique nanométrique.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation on prévoit un procédé de fabrication d'un actuateur électromécanique, de préférence nanométrique, comprenant une électrode fixe d'actuation, une électrode fixe de contact et une électrode mobile, l'actuateur comprenant en outre un empilement de couches, l'électrode mobile comprenant une partie d'ancrage solidaire de l'empilement de couches et une partie mobile configurée pour présenter une position de repos et une position de contact, la position de repos correspondant à une absence de contact entre la partie mobile de l'électrode mobile et l'électrode fixe de contact, la position de contact correspondant à un contact entre la partie mobile de l'électrode mobile et l'électrode fixe de contact lorsqu'une polarisation non nulle est appliquée entre l'électrode mobile et l'électrode fixe d'actuation, ledit procédé comprenant les étapes suivantes :
a) Fourniture d'un empilement primaire de couches comprenant :
   i. Un premier substrat ;
   ii. Une couche monocristalline disposée sur une surface supérieure du premier substrat ;
   iii. Une couche intercalaire disposée sur une surface supérieure de la couche monocristalline ;
   iv. Une couche de gravure disposée sur une surface supérieure de la couche intercalaire ;
b) Fourniture d'un empilement secondaire de couches comprenant :
   i. Un deuxième substrat ;
   ii. Une couche de report disposée sur une surface supérieure du deuxième substrat ;
c) Formation par gravure dans la couche de gravure d'au moins trois plots, sélectivement à la couche intercalaire ;
d) Encapsulation des trois plots par une première couche d'encapsulation ;
e) Assemblage de l'empilement primaire de couches avec l'empilement secondaire de couches par collage d'une partie au moins de la surface exposée de la première couche d'encapsulation avec une partie au moins de la surface exposée de la couche de report de sorte à former une interface de collage ;
f) Retrait du premier substrat ;
g) Formation par gravure de la partie d'ancrage et de la partie mobile de l'électrode mobile dans la couche monocristalline ;
h) Retrait d'une partie sacrificielle de la couche intercalaire configuré pour libérer la partie mobile de l'électrode mobile et de sorte à préserver une partie de la couche intercalaire entre la partie d'ancrage de l'électrode mobile et une partie au moins d'un des trois plots ;

Cela permet de réaliser un actuateur électromécanique dont l'élément mobile est monocristallin. Cela permet d'améliorer la réponse électromécanique de l'actuateur.

La monocristallinité de l'électrode mobile permet un meilleur contrôle des tensions de polarisation nécessaire à son déplacement.

Le collage permet l'utilisation de divers substrats et ainsi de divers types de matériaux monocristallin si souhaité.

Cela permet également de réaliser un actuateur électromécanique présentant un gap réduit par rapport à l'art antérieur.

Un autre aspect concerne un actuateur comprenant au moins une électrode fixe d'actuation, une électrode fixe de contact et une électrode mobile, l'actuateur comprenant au moins un empilement de couches, l'électrode mobile comprenant au moins une partie d'ancrage solidaire de l'empilement de couches et une partie mobile configurée pour présenter une position de repos et une position de contact, la position de repos correspondant à une absence de contact entre la partie mobile de l'électrode mobile et l'électrode fixe de contact, la position de contact correspondant à un contact entre la partie mobile de l'électrode mobile et l'électrode fixe de contact lorsqu'une polarisation non nulle est appliquée entre l'électrode mobile et l'électrode fixe d'actuation, ledit actuateur étant caractérisé en ce que l'électrode mobile est formée d'un matériau monocristallin et en ce que la partie d'ancrage est solidaire de l'empilement de couches au travers d'une couche intercalaire.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente un actuateur électromécanique nanométrique selon un mode de réalisation de la présente invention.
La figure 2 représente une partie des étapes d'un procédé de fabrication d'un actuateur électromécanique nanométrique selon un mode de réalisation de la présente invention.
La figure 3 représente un empilement primaire de couches selon un mode de réalisation de la présente invention.
La figure 4 représente un empilement secondaire de couches selon un mode de réalisation de la présente invention
La figure 5 représente la réalisation de plots selon un mode de réalisation de la présente invention.
La figure 6 représente trois plots réalisés selon un mode de réalisation de la présente invention.
La figure 7 représente une étape d'encapsulation des trois plots selon un mode de réalisation de la présente invention.
La figure 8 représente une étape de planarisation de la couche d'encapsulation de la figure 7 selon un mode de réalisation de la présente invention.
La figure 9 représente une étape de collage de l'empilement primaire de couches avec l'empilement secondaire de couches selon un mode de réalisation de la présente invention.
La figure 10 représente l'assemblage de l'empilement primaire de couches avec l'empilement secondaire de couches selon un mode de réalisation de la présente invention.
La figure 11 représente le retrait du premier substrat de l'empilement primaire de couches selon un mode de réalisation de la présente invention.
La figure 12 représente une vue de dessus de la figure 11 avec la disposition d'un deuxième masque de gravure sur la couche monocristalline selon un mode de réalisation de la présente invention.
La figure 13 représente une vue en coupe de la figure 12 et l'étape de disposition du deuxième masque de gravure sur la couche monocristalline selon un mode de réalisation de la présente invention.
La figure 14 représente une étape de conformation du deuxième masque de gravure de sorte à définir les pourtours de l'électrode mobile en formation selon un mode de réalisation de la présente invention.
La figure 15 représente une étape de gravure d'une partie de la couche monocristalline et de la couche intercalaire selon un mode de réalisation de la présente invention.
La figure 16 représente une étape de retrait du deuxième masque de gravure selon un mode de réalisation de la présente invention.
La figure 17 représente une étape d'encapsulation de l'électrode mobile selon un mode de réalisation de la présente invention.
La figure 18 représente une étape de planarisation de la couche d'encapsulation selon un mode de réalisation de la présente invention.
La figure 19 représente une étape de formation d'ouvertures dans un troisième masque de gravure à l'aplomb des trois plots selon un mode de réalisation de la présente invention.
La figure 20 représente une étape de formation d'ouvertures dans la deuxième couche d'encapsulation selon un mode de réalisation de la présente invention.
La figure 21 représente une étape de dépôt d'une pluralité de couches conductrices électriques selon un mode de réalisation de la présente invention.
La figure 22 représente le dépôt d'un quatrième masque de gravure selon un mode de réalisation de la présente invention.
La figure 23 représente la formation de trois contacts électriques selon un mode de réalisation de la présente invention.
La figure 24 représente une étape de retrait d'une partie au moins de la deuxième couche d'encapsulation selon un mode de réalisation de la présente invention.
La figure 25 représente une étape de retrait de la partie de la couche intercalaire située sous la partie mobile de l'électrode mobile de sorte à former un gap entre cette partie mobile et les deux autres électrodes selon un mode de réalisation de la présente invention.
La figure 26 représente une vue de dessus d'un actuateur électromécanique nanométrique selon un mode de réalisation de la présente invention.
La figure 27 représente une vue de dessus d'un actuateur électromécanique nanométrique double selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la couche monocristalline est à base de et/ou comprend au moins un matériau pris parmi : un semi-conducteur, un conducteur électrique.

Selon un exemple, la couche de gravure est une couche monocristalline.

Selon un autre exemple, la couche de gravure est une couche épitaxiée.

Selon un autre exemple, la couche de gravure est une couche polycristalline.

Selon un autre exemple, la couche de gravure est une couche amorphe.

Selon un exemple, la structure cristalline de la couche monocristalline est différente de la structure cristalline de la couche de gravure.

Selon un exemple, la couche monocristalline et la couche de gravure sont à base du même matériau.

Selon un exemple, la couche de gravure est obtenue par croissance épitaxiale d'un matériau identique au matériau composant la couche monocristalline et à partir de la couche intercalaire.

Selon un exemple, la couche intercalaire présente une dimension en épaisseur inférieure ou égale à la dimension en épaisseur de la couche monocristalline, les dimensions en épaisseur étant prises selon un axe orthogonal à la dimension d'extension principale des couches considérées.

Selon un exemple, la couche monocristalline est à base de silicium monocristallin, la couche intercalaire est à base de silicium et de germanium et la couche de gravure est à base de silicium.

Selon un exemple, le collage est un collage moléculaire.

Selon un exemple, le procédé comprend, avant l'étape d'assemblage, une étape de planarisation de la surface exposée de la première couche d'encapsulation de sorte à exposer en partie au moins une surface d'au moins un des trois plots, et l'interface de collage est formée en partie au moins d'une portion de la surface d'un des trois plots, d'une partie au moins de la surface exposée de la première couche d'encapsulation et d'une partie au moins de la surface exposée de la couche de report.

Selon un exemple, l'étape de retrait d'une partie de la couche intercalaire comprend au moins une gravure humide ou anhydre configurée pour retirer une partie sacrificielle de la couche intercalaire supportant la partie mobile de l'électrode mobile.

Selon un exemple, le procédé comprend une étape de formation d'au moins un contact électrique pour chaque plot.

Selon un exemple, la partie mobile de l'électrode mobile est suspendue par la partie d'ancrage de l'électrode mobile au-dessus d'une partie au moins de l'électrode fixe d'actuation en position de repos, la distance séparant la partie mobile et la partie de l'électrode fixe d'actuation est inférieure à 20nm, de préférence à 15nm et avantageusement égale à 12nm en position de repos.

Selon un exemple, l'actuateur comprend au moins une interface de collage issue du collage d'un empilement primaire de couches avec un empilement secondaire de couches.

Il est précisé que dans le cadre de la présente invention, le terme « sur », « surmonte », « recouvre » ou « sous-jacent » ou leurs équivalents ne signifient pas « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

Dans la présente demande de brevet, l'épaisseur est prise selon une direction perpendiculaire aux faces principales du substrat sur lequel repose les différentes couches. Sur les figures, l'épaisseur est prise selon la verticale.

La présente invention concerne un actuateur électromécanique nanométrique et son procédé de fabrication. Ce dispositif présente de manière avantageuse un gap inférieur à 50nm ce qui lui permet une plus grande réactivité. De même, ce dispositif présente une électrode mobile monocristalline ce qui permet ici encore d'accroitre la réactivité, la fiabilité et la durabilité du dispositif. Ces avantages sont rendus en partie possibles par la configuration du dispositif et par son procédé de fabrication.

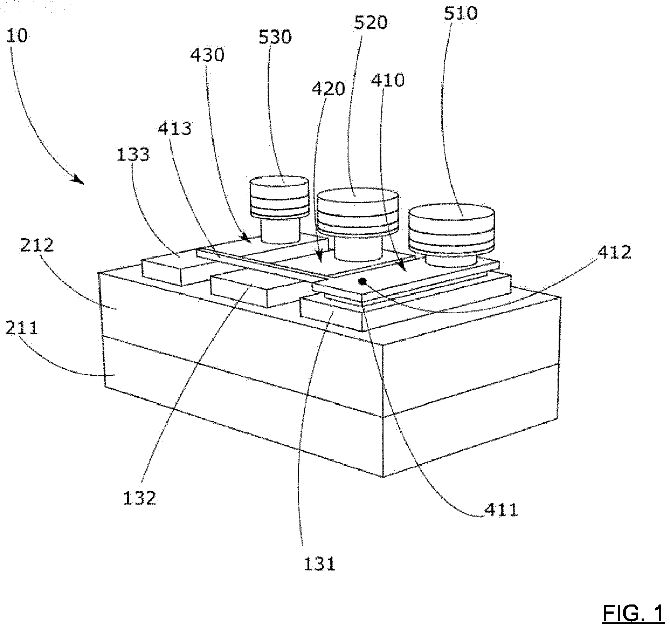

La figure 1 représente, selon un mode de réalisation de la présente invention, un actuateur électromécanique nanométrique 10. Cet actuateur 10 comprend trois contacts électriques 510, 520 et 530, chacun connecté à un plot 131, 132 et 133. Chaque ensemble contact électrique/plot forme une électrode 410, 420 et 430. Ce dispositif 10 comprend alors une électrode fixe de contact 430, une électrode fixe d'actuation 420 et une électrode mobile 410.

Cette électrode mobile 410 comprend une partie d'ancrage 412 solidaire d'un plot 131 et d'un contact électrique 510 au travers d'une couche intercalaire 411. Cette électrode mobile 410 comprend une partie mobile 413, de préférence sous la forme d'une poutre suspendue au-dessus des deux autres plots 132 et 133. Cette électrode mobile 410 est configurée pour présenter avantageusement deux positions, une position dite de repos et une position dite de contact. La position de repos correspond à une absence de contact entre la partie mobile 413 de l'électrode mobile 410 et l'électrode fixe de contact 430. La position de contact correspond à un contact entre la partie mobile 413 de l'électrode mobile 410 et l'électrode fixe de contact 430 lorsqu'une polarisation non nulle est appliquée entre l'électrode mobile 410 et l'électrode fixe d'actuation 420. La force électrostatique alors exercée sur la partie mobile 413 de l'électrode mobile 410 incline celle-ci au point qu'elle entre en contact électrique avec l'électrode fixe de contact 430.

On notera en particulier, que selon un mode de réalisation illustré en figure 1, l'électrode fixe d'actuation 420 est disposée entre l'électrode fixe de contact 430 et la partie d'ancrage de l'électrode mobile 410. Dans cette configuration, et avantageusement, c'est l'extrémité libre de la poutre de la partie mobile 413 de l'électrode mobile 410 qui est configurée pour venir en partie au moins en contact électrique avec l'électrode fixe de contact 430 en position de contact.

Ces trois électrodes 410, 420 et 430 sont supportées par un empilement de couches dit secondaire 200 comprenant un substrat, appelé deuxième substrat 211 par la suite, et une couche de report 212.

Selon un mode de réalisation préféré, cette couche de report 212 comprend une interface de collage 142 située entre les trois plots 131, 132 et 133 et le deuxième substrat 212 tel que cela sera décrit par la suite.

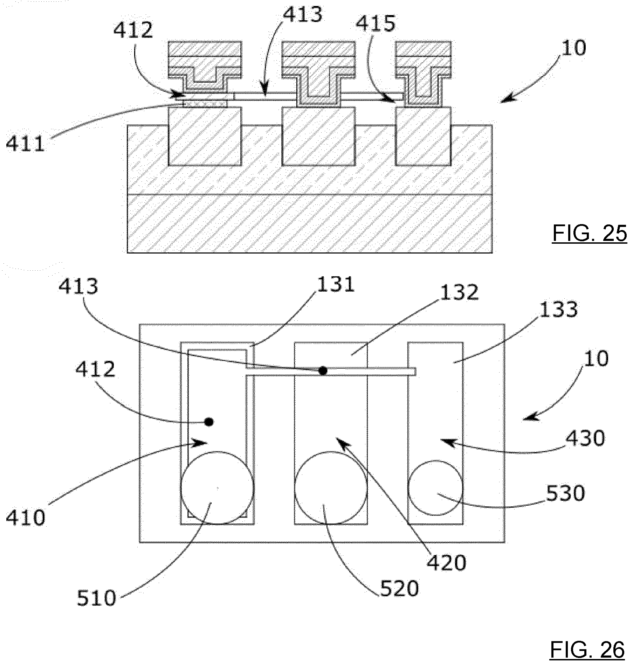

Sur cette figure ainsi que la figure 25, on notera le gap 415, c'est-à-dire la distance située entre la partie mobile 413 de l'électrode mobile 410 et le plot 133 de l'électrode de contact 430 lorsque l'électrode mobile 410 est en position de repos. De préférence, la surface supérieure des plots 132 et 133 sont coplanaires définissant ainsi un gap 415 constant entre la partie mobile 413 de l'électrode mobile 410 et à la fois la surface supérieure du plot 132 et la surface supérieure du plot 133 des deux autres électrodes 420 et 430. Ce gap 415 est de préférence égal à la dimension en épaisseur de la couche intercalaire 411. Cette couche intercalaire 411 est de préférence à base de silicium-germanium (SiGe). Ce gap 415 est avantageusement inférieur à 20nm, de préférence à 15nm et préférentiellement égal à 12nm.

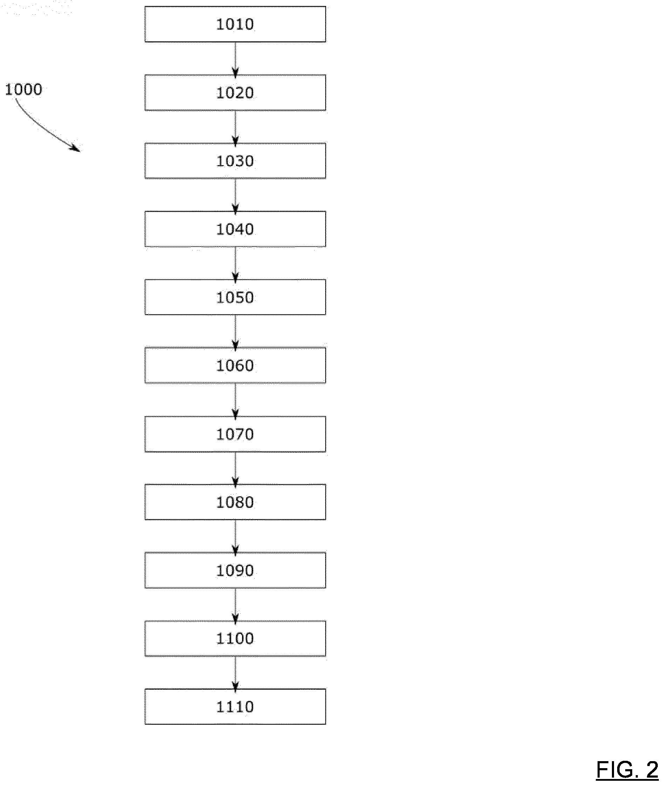

La figure 2 illustre une représentation schématique d'un mode de réalisation du procédé 1000 selon la présente invention.

Selon un mode de réalisation, le procédé 1000 de fabrication comprend au moins les étapes suivantes :
a) Fourniture 1010 d'un empilement primaire de couches 100 comprenant :
   i. Un premier substrat 110 ;
   ii. Une couche monocristalline 120 disposée sur une surface supérieure du premier substrat 110 ;
   iii. Une couche intercalaire 411 disposée sur une surface supérieure de la couche monocristalline 120 ;
   iv. Une couche de gravure 130 disposée sur une surface supérieure de la couche intercalaire 411 ;
b) Fourniture 1020 d'un empilement secondaire de couches 200 comprenant :
   i. Un deuxième substrat 211 ;
   ii. Une couche de report 212 disposée sur une surface supérieure du deuxième substrat 211 ;
c) Formation 1030, de préférence par gravure, d'au moins trois plots 131, 132 et 133 dans la première couche de gravure 130, sélectivement à la couche intercalaire 411 ;
d) Encapsulation 1040 des trois plots 131, 132 et 133 par une première couche d'encapsulation 140 ;
e) De préférence, planarisation 1050 de la surface exposée de la première couche d'encapsulation 140 ;
f) Assemblage 1060 de l'empilement primaire de couches 100 avec l'empilement secondaire de couches 200 par collage d'une partie au moins de la surface exposée 141 de la première couche d'encapsulation 140 avec la surface exposée 213 de la couche de report 212 de sorte à former une interface de collage 142 ;
g) Retrait 1070 du premier substrat 100 de sorte à exposer une partie au moins de la couche monocristalline 120 ;
h) Formation 1080 par gravure de la partie d'ancrage 412 et de la partie mobile 413 de l'électrode mobile 410 dans la couche monocristalline 120 ;
i) De préférence, retrait 1090 d'une portion de la couche intercalaire 411 de sorte à conserver la couche intercalaire 411 au moins sous l'électrode mobile 410, ladite couche intercalaire 411 formant ainsi une couche de support pour l'électrode mobile 410 et en particulier pour la partie d'ancrage 412 et la partie mobile 413 de l'électrode mobile 410 ;
j) Retrait 1100 d'une partie sacrificielle 414 de la couche intercalaire 411 configuré pour libérer la partie mobile 413 de l'électrode mobile 410 et de sorte à préserver une de la couche intercalaire 411 entre la partie d'ancrage 412 et une partie au moins d'un des trois plots 131 ;
k) De préférence, avant ou après la formation 1080 de la partie d'ancrage 412 et de la partie mobile 413 de l'électrode mobile 410, formation 1110 de contacts électrique 510, 520 et 530 au-dessus d'une partie au moins de chacun des trois plots 131, 132 et 133.

Ce procédé 1000 permet de manière astucieuse d'obtenir le dispositif 10 précédemment présenté comprenant une électrode mobile 410 monocristalline espacée en hauteur des électrodes fixes de contact 430 et d'actuation 420 d'une distance très faible relativement à l'art antérieur, distance couramment appelée gap 415. Comme décrit par la suite, c'est en partie au moins par l'étape de collage 1060 et l'utilisation d'une gravure 1100 humide ou anhydre que ce dispositif 10 peut ainsi être fabriqué.

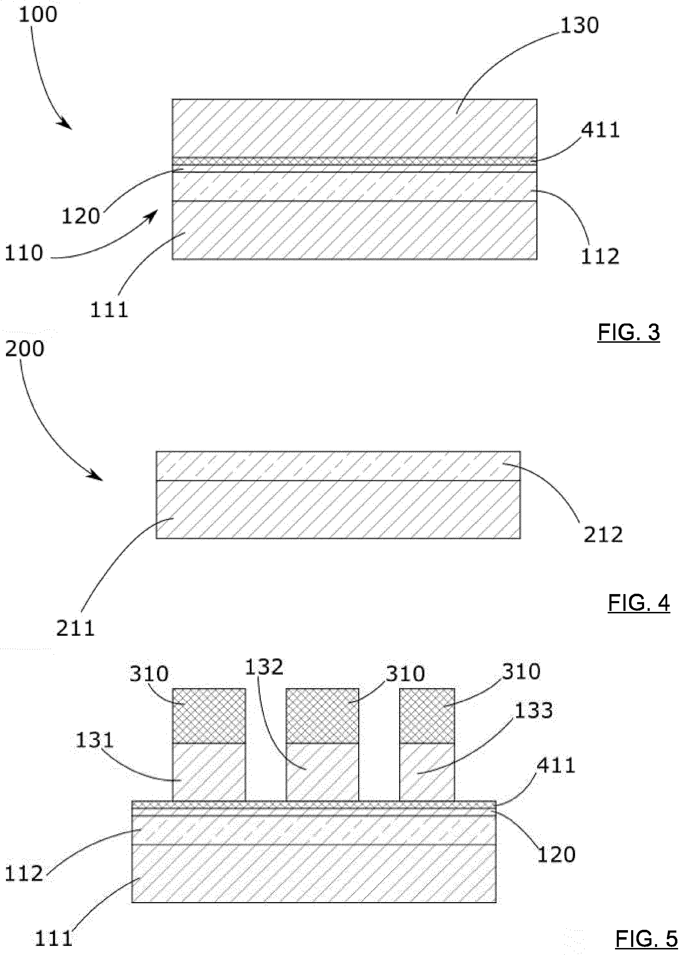

La figure 3 représente l'empilement primaire de couches 100. Le premier substrat 110 comprend de préférence au moins une couche support 111 et une couche d'interface 112.

La couche support 111 est de préférence en matériau semi-conducteur et en particulier à base de silicium.

La couche d'interface 112 est avantageusement à base d'un matériau diélectrique, par exemple un nitrure ou un oxyde de semi-conducteur, et de préférence en oxyde de silicium.

La couche monocristalline 120 est de préférence à base de silicium monocristallin. La couche monocristalline 120 peut présenter une dimension en épaisseur inférieure à 20nm, de préférence à 15nm et avantageusement égale à 12nm.

De préférence, on entend par « monocristallin » un matériau ou une couche présentant une structure cristalline homogène et continue, de préférence sans joints de grains. On notera en particulier qu'une couche épitaxiée n'est pas considérée comme une couche monocristalline dans la présente description.

La couche intercalaire 411 est de préférence à base de SiGe. La couche intercalaire 411 peut présenter une dimension en épaisseur inférieure à 20nm, de préférence à 15nm et avantageusement égale à 12nm.

Selon un mode de réalisation préféré, la couche de gravure 130 est de préférence à base d'un matériau épitaxié. Cela permet de réduire l'introduction de contraintes mécaniques dans l'empilement de couches primaire 100. Selon ce mode de réalisation, la couche de gravure 130 est une couche épitaxiée, et non monocristalline.

Selon un autre mode de réalisation, la couche de gravure 130 est monocristalline.

Préférentiellement la couche de gravure 130 est à base de silicium, avantageusement épitaxié ou monocristallin. On notera que le mode de réalisation dans lequel la couche de gravure 130 est monocristalline permet d'éviter la présence de contraintes mécaniques dans l'empilement de couches primaire 100.

La couche de gravure 130 peut présenter une dimension en épaisseur supérieure à 20nm, de préférence à 50nm et avantageusement égale à 100nm.

Selon un mode de réalisation, la couche de gravure 130 est dopée de sorte à la rendre conductrice électrique ou plus conductrice. Cela permet de réduire la résistivité électrique de la couche de gravure 130, par exemple dans le cas où celle-ci serait à base d'un matériau semi-conducteur, voire isolant. Cela permet ainsi de réduire le délai de propagation d'un signal électrique traversant la couche de gravure 130.

Selon un mode de réalisation, la couche de gravure 130 est à base du même matériau que la couche monocristalline 120, et la structure cristallographique de la couche de gravure 130 est différente de la structure cristallographique de la couche monocristalline 120. On entend par structure cristallographique différente le fait par exemple que l'orientation cristallographique et/ou que les paramètres de maille et/ou le taux d'impureté soient différents entre deux couches d'un même matériau.

La figure 4 représente l'empilement secondaire de couches 200.

Le deuxième substrat 211 est de préférence à base de silicium, avantageusement monocristallin.

La couche de report 212 est de préférence à base d'un matériau diélectrique. La couche de report 212 est avantageusement à base d'oxyde de silicium.

La couche de report 212 présente une dimension en épaisseur supérieure à 50nm, de préférence à 150nm et avantageusement égale à 400nm.

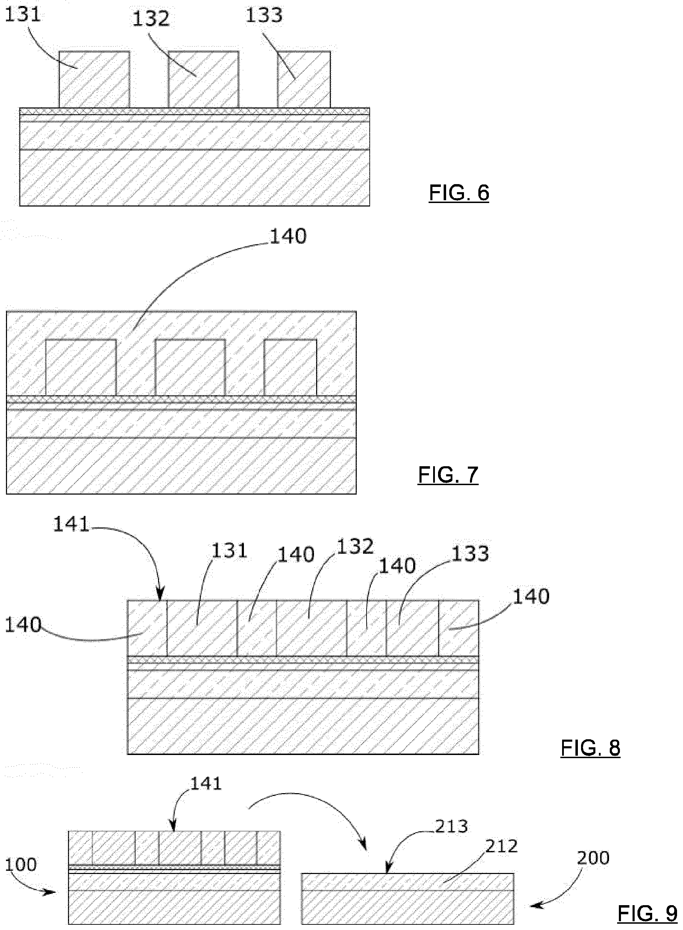

Les figures 5 et 6 représentent l'étape de formation 1030 des trois plots 131, 132 et 133 dans la couche de gravure 130. On notera que cette étape comprend la disposition d'un premier masque de gravure 310 sur une partie au moins de la surface exposée de la couche de gravure 130 de sorte à définir les trois plots 131, 132 et 133 à former. De préférence, on entend par masque de gravure toute couche de résine ou tout masque dur utilisé pour protéger une ou plusieurs parties d'une couche ou de plusieurs couches lors d'une gravure.

Cette étape 1030 comprend une gravure de la couche de gravure 130. De préférence, la gravure se poursuit jusqu'à exposer une partie au moins de la couche intercalaire 411 située entre chaque plot 131, 132 et 133 ainsi formé.

Selon un mode de réalisation, cette gravure peut comprendre une gravure par plasma à base d'une chimie Cl₂ / HBr.

Selon un autre mode de réalisation, cette gravure peut comprendre une gravure à base de CF₄ / N₂ et O₂.

On notera que les trois plots 131, 132 et 133 présentent une dimension en épaisseur sensiblement égale. On notera également que le premier plot 131 présente une dimension d'extension en largeur supérieure à celle du deuxième plot 132, et que le deuxième plot 132 présente une dimension d'extension en largeur supérieure à celle du troisième plot 133.

De manière avantageuse, le premier plot 131 est configuré pour supporter la partie d'ancrage 412 de l'électrode mobile 410. Le deuxième plot 132 est de préférence configuré pour former en partie au moins l'électrode fixe d'actuation 420. De préférence, le troisième plot 133 est configuré pour former en partie au moins l'électrode fixe de contact 430.

La figure 7 représente l'étape d'encapsulation 1040 par la première couche d'encapsulation des trois plots 131, 132 et 133 ainsi formés. La première couche d'encapsulation 140 est de préférence à base d'un matériau diélectrique, avantageusement à base d'oxyde de silicium. On notera que la dimension en épaisseur de la première couche d'encapsulation 140 est supérieure à la dimension en épaisseur de chaque plot 131, 132 et 133.

La figure 8 représente une étape de planarisation 1050 de la surface exposée 141 de la première couche d'encapsulation. La planarisation 1050 peut être réalisée jusqu'à exposer une partie au moins des trois plots 131, 132 et 133 selon un mode de réalisation. Cette étape de planarisation 1050 peut utiliser une méthode de planarisation mécano-chimique.

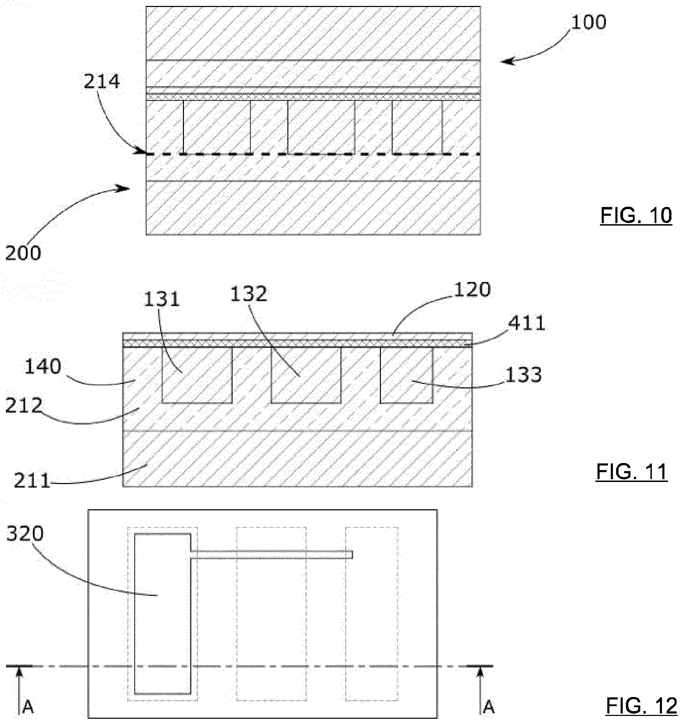

Les figures 9 et 10 illustrent le collage 1060 d'une partie au moins de la surface planarisée 141 de la première couche d'encapsulation 140 avec la surface exposée 213 de la couche de report 212 de l'empilement secondaire de couche 200. Ce collage est avantageusement un collage moléculaire. On notera que ce collage donne naissance à une interface de collage 214. Cette interface de collage 214 peut être soit située entre la surface précédemment exposée d'un plot 131, 132 ou 133 et la surface exposée 213 de la couche de support 212 et/ou entre une partie de la surface planarisée 141 de la première couche d'encapsulation 140 et la surface exposée 213 de la couche de support 212.

La figure 11 illustre l'étape de retrait 1070 du premier substrat 110. Cette étape de retrait 1070 peut comprendre une étape de gravure sélectivement à la couche monocristalline 120. Cette étape permet d'exposer la couche monocristalline 120.

A présent, la couche monocristalline 120 est disposée au-dessus de la couche intercalaire 411, elle-même disposée en partie au moins au-dessus des trois plots 131, 132 et 133, le tout étant supporté par l'empilement secondaire de couches 200.

Les figures 12 à 15 illustrent la conformation de la couche monocristalline 120 en partie d'ancrage 412 et en partie mobile 413 de l'électrode mobile 410.

La figure 12 représente une vue de dessus de la disposition sur la couche monocristalline 120 et de la conformation d'un deuxième masque de gravure 320 de sorte à définir la forme géométrique souhaitée pour l'électrode mobile 410.

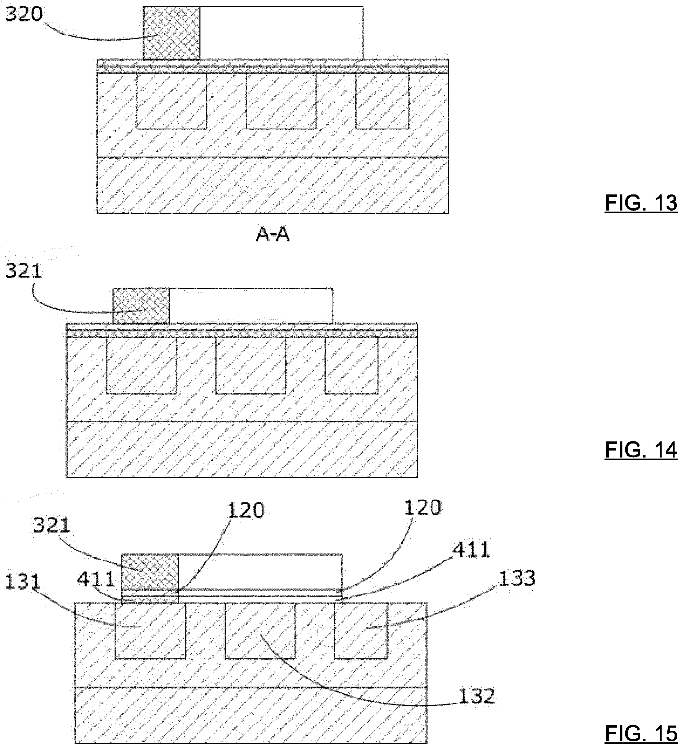

La figure 13 illustre une vue en coupe de cette disposition et de cette conformation.

La figure 14 représente une étape optionnelle consistant à affiner la géométrie du deuxième masque de gravure 320. Cela permet d'optimiser la forme géométrique souhaitée pour l'électrode mobile 410.

La figure 15 illustre la formation 1080 de la partie d'ancrage 412 et de la partie mobile 413 de l'électrode mobile 410. Cette étape de formation 1080 comprend la gravure d'une partie au moins de la couche monocristalline 120 et de préférence d'une partie au moins de la couche intercalaire 411, de préférence sélectivement au deuxième masque de gravure 320. Cette gravure se poursuit de préférence jusqu'à exposer une partie au moins des plots 131, 132 et 133 et avantageusement de la première couche d'encapsulation 140 située entre les plots 131, 132 et 133.

Cette étape de gravure peut être réalisée par gravure plasma en présence de chimie Cl₂ / HBr par exemple et peut être poursuivie jusqu'à exposition d'une partie au moins de la première couche d'encapsulation 140.

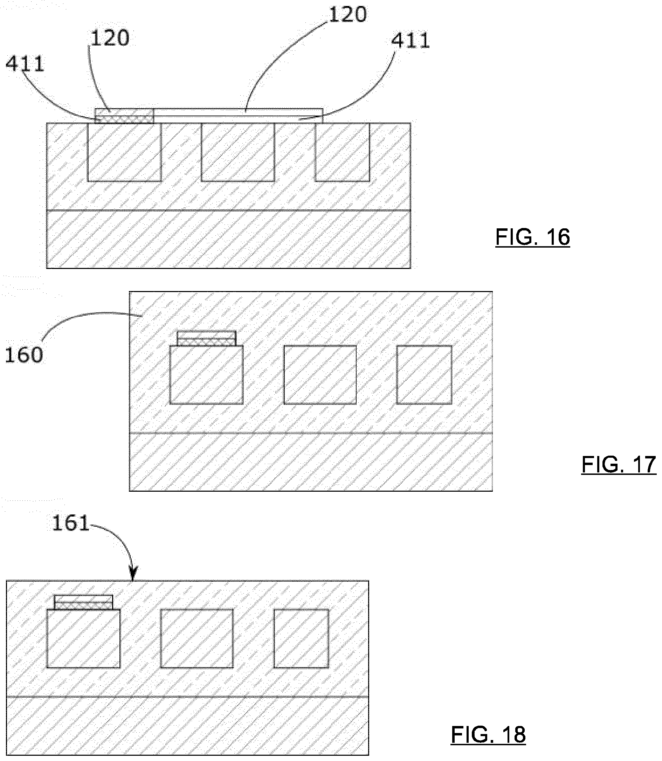

La figure 16 illustre le retrait du deuxième masque de gravure 320. On note alors que la couche monocristalline 120 est conformée selon la géométrie souhaitée pour la première électrode 410. La couche monocristalline 120 est supportée par une partie de la couche intercalaire 411. La couche monocristalline 120 comprend la partie d'ancrage 412 la solidarisant au premier plot 131 au travers d'une portion de support de la couche intercalaire 411 et une partie mobile 413, de préférence longitudinale destinée à être suspendue au-dessus d'une partie du deuxième plot 132 et du troisième plot 133.

Sur la figure 16, la partie 413 destinée à être suspendue est pour le moment supportée par une partie sacrificielle 414 de la couche intercalaire 411.

La figure 17 illustre une étape d'encapsulation de la couche monocristalline 120 par une deuxième couche d'encapsulation 160. Cette deuxième couche d'encapsulation 160 étant de préférence à base d'un matériau diélectrique et de préférence d'oxyde de silicium.

La figure 18 illustre une étape optionnelle de planarisation de la surface exposée 161 de la deuxième couche d'encapsulation 160. Cette planarisation est avantageusement réalisée par une technique de planarisation mécano-chimique.

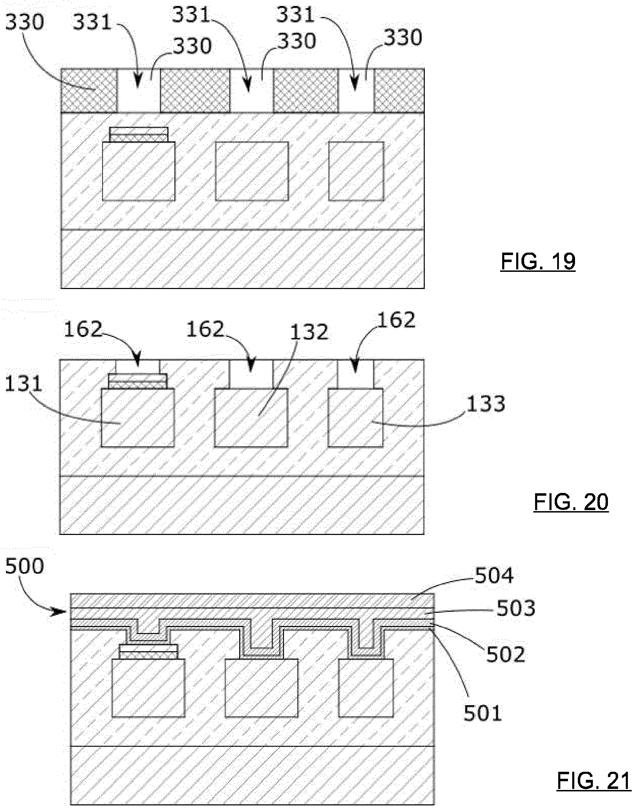

La figure 19 représente la disposition d'un troisième masque de gravure 330 et la formation dans ce troisième masque de gravure 330 d'ouvertures 331, de préférence disposée à l'aplomb des plots 131, 132 et 133.

La figure 20 représente alors la gravure de la deuxième couche d'encapsulation 160 au niveau de chacune des ouvertures 331 formées à l'aplomb des plots 131, 132 et 133. Cette étape de gravure permet de définir des ouvertures 162 dans la deuxième couche d'encapsulation 160 à l'aplomb de chaque plot 131, 132 et 133 et de sorte à exposer une partie au moins de chaque plot 131, 132 et 133.

Les figures 21 à 23 illustrent les étapes de formations 1110 de contacts électriques 510, 520 et 530. Chaque plot 131, 132 et 133 comprend ainsi un contact électrique 510, 50 et 530 configuré pour permettre une polarisation, au moyen de l'électrode d'actuation 420, de l'électrode mobile 410 et sa mise en contact électrique avec l'électrode fixe de contact 430.

La figure 21 représente le dépôt d'une couche de métallisation 500 sur une partie au moins de la surface du dispositif 10 en cours de fabrication, l'objectif ici étant de remplir les ouvertures 161 précédemment réalisées dans la deuxième couche d'encapsulation 160 par une partie au moins de cette couche de métallisation 500.

De manière préférée, cette couche de métallisation 500 comprend une pluralité de sous couches 501, 502, 503 et 504. La première sous-couche 501 est par exemple à base de titane, la deuxième sous-couche 502 est par exemple à base de nitrure de titane, la troisième sous-couche 503 est par exemple à base de tungstène et la quatrième sous-couche 504 est à base d'un mélange d'aluminium et de silicium.

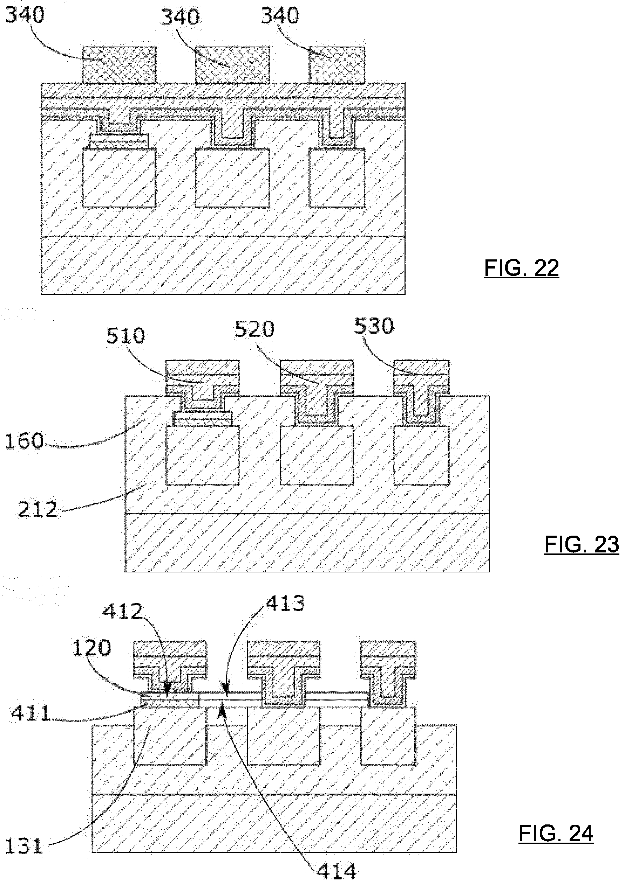

La figure 22 représente le positionnement d'un quatrième masque de gravure 340 sur la couche de métallisation 500 à l'aplomb des plots 131, 132 et 133.

Puis la figure 23 représente l'étape de gravure de la couche de métallisation 500 sélectivement à la deuxième couche d'encapsulation 160 de sorte à définir au moins un contact électrique 510, 520 et 530 pour chaque plot 131, 132 et 133.

La figure 24 illustre ensuite une étape de retrait d'une partie au moins de l'épaisseur de la deuxième couche d'encapsulation 160. Cette étape de gravure peut comprendre une gravure en phase vapeur, en chimie HF par exemple. Cette gravure est avantageusement sélective par rapport aux plots 131, 132 et 133, à l'électrode mobile 410 et à la couche intercalaire 411.

Cette étape de gravure permet d'exposer une surface de la couche intercalaire 411, surface au regard de la surface de la portion résiduelle de la deuxième couche d'encapsulation 160.

La figure 25 illustre alors le retrait 1100 de la partie sacrificielle 414 de la couche intercalaire 411, c'est-à-dire la gravure de la partie de la couche intercalaire 411 solidarisant la partie mobile 413 de l'électrode mobile 410 avec le deuxième plot 132 et avec le troisième plot 133.

Cette gravure est avantageusement une gravure humide ou anhydre. L'objectif d'une telle gravure et de pouvoir retirer la partie sacrificielle 414 de la couche intercalaire 411 sans laisser subsister de trace de ladite couche intercalaire 411 sous la partie mobile 413 de l'électrode mobile 410, tout en conservant une partie de cette couche intercalaire 411 sous la partie d'ancrage 412 de l'électrode mobile 410.

En effet, la poutre définissant la partie mobile 413 de l'électrode mobile 410 est alors disposée en suspension en supprimant la partie sacrificielle 414 de la couche intercalaire 411. Cela crée alors le gap 415 précédemment discuté.

Selon un mode de réalisation, cette gravure est une gravure plasma à base de CF4.

Selon un autre mode de réalisation, cette gravure est une gravure en phase vapeur à base de HCl.

On notera que seule la partie sacrificielle 414 de la couche intercalaire 411, c'est-à-dire la partie située au contact, et de préférence sous, la partie mobile 413 de l'électrode mobile 410 est retirée, de préférence intégralement. Il demeure une partie de la couche intercalaire 411 sous la partie d'ancrage 412 de l'électrode mobile 410 la reliant mécaniquement et électriquement au premier plot 131 et donc au contact électrique 510 du premier plot 131.

La figure 26 représente une vue du dessus de l'actuateur 10 de la figure 1 réalisé par le procédé 1000 précédemment décrit. On notera la forme de la partie mobile 413 de l'électrode mobile 410 qui s'étend longitudinalement de sorte à être suspendue au-dessus des deux autres électrodes 420 et 430.

Ce procédé 1000 permet ainsi d'obtenir un actuateur électromécanique nanométrique 10 présentant une réponse électromécanique accrue et un gap 415 extrêmement réduit relativement à l'art antérieur.

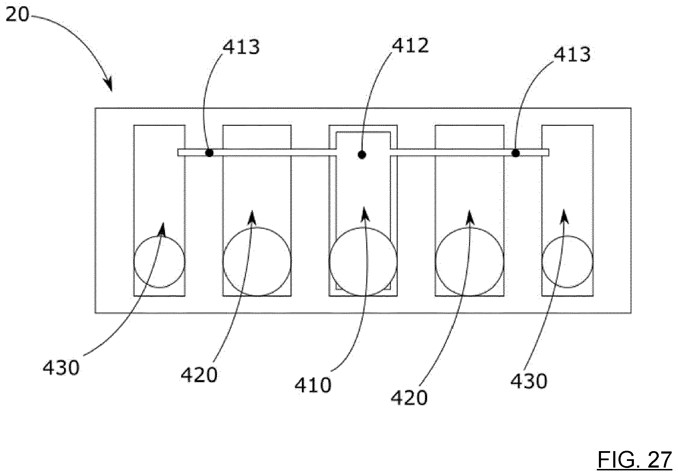

Selon un mode de réalisation illustré en figure 27, il est également possible, via ce même procédé, de réaliser une pluralité d'actuateurs 10. Sur la figure 27, il s'agit d'un actuateur double 20 comprenant deux parties mobiles 413 solidaires l'une de l'autre par une même partie d'ancrage 412. Sur cette figure, il y a alors deux électrodes fixes de contact 430 et deux électrodes fixes d'actuation 420.

Selon un mode de réalisation, et en particulier en fonction de l'épaisseur de l'électrode mobile 410 et des propriétés mécaniques de la couche intercalaire 411, la première partie mobile 413 et la deuxième partie mobile 413 peuvent être soit indépendantes l'une de l'autre dans leur position, soit être anti-corrélées l'une avec l'autre, de sorte que lorsque l'une est en position de contact, l'autre est en position de repos obligatoirement par exemple.

La présente invention permet ainsi un gain important en fiabilité, reproductibilité et longévité en réalisant une électrode mobile monocristalline suspendue à une très faible distance au-dessus des électrodes fixes de contact et d'actuation par rapport à l'art antérieur.

L'invention n'est pas limitée aux modes de réalisations précédemment décrits et s'étend à tous les modes de réalisation couverts par les revendications.

### LISTE DES REFERENCES

- 10: Actuateur électromécanique nanométrique
- 20: Double actuateur électromécanique nanométrique
- 100: Empilement primaire de couches
- 110: Premier substrat
- 111: Couche support
- 112: Couche superficielle
- 120: Couche monocristalline
- 130: Couche de gravure
- 131: Premier plot
- 132: Deuxième plot
- 133: Troisième plot
- 140: Première couche d'encapsulation
- 141: Surface planarisée de la première couche d'encapsulation
- 160: Deuxième couche d'encapsulation
- 161: Surface planarisée de la deuxième couche d'encapsulation
- 162: Ouvertures dans la deuxième couche d'encapsulation
- 200: Empilement secondaire de couches
- 211: Deuxième substrat
- 212: Couche de report
- 213: Surface exposée de la couche de report
- 214: Interface de collage
- 310: Premier masque de gravure
- 320: Deuxième masque de gravure
- 321: Deuxième masque de gravure affiné
- 330: Troisième masque de gravure
- 331: Ouvertures dans le troisième masque de gravure
- 340: Quatrième masque de gravure
- 410: Electrode mobile
- 411: Couche intercalaire
- 412: Partie d'ancrage
- 413: Partie mobile
- 414: Partie sacrificielle de la couche intercalaire
- 415: Gap
- 420: Electrode fixe d'actuation
- 430: Electrode fixe de contact
- 500: Couche de métallisation
- 501: Première sous-couche de métallisation
- 502: Deuxième sous-couche de métallisation
- 503: Troisième sous-couche de métallisation
- 504: Quatrième sous-couche de métallisation
- 510: Premier contact électrique
- 520: Deuxième contact électrique
- 530: Troisième contact électrique
- 1000: Procédé de fabrication
- 1010: Fourniture d'un empilement primaire de couches
- 1020: Fourniture d'un empilement secondaire de couches
- 1030: Formation de trois plots dans la première couche de gravure
- 1040: Encapsulation des trois plots par une première couche d'encapsulation
- 1050: Planarisation de la surface exposée de la première couche d'encapsulation
- 1060: Assemblage de l'empilement primaire de couches avec l'empilement secondaire de couches
- 1070: Retrait du premier substrat
- 1080: Formation par gravure de l'électrode mobile dans la couche monocristalline
- 1090: Retrait d'une portion de la couche intercalaire
- 1100: Retrait d'une partie sacrificielle de la couche intercalaire
- 1110: Formation de contacts électrique au-dessus d'une partie au moins de chacun des trois plots

## Revendications

1. Procédé (1000) de fabrication d'un actuateur électromécanique (10, 20), de préférence nanométrique, comprenant une électrode fixe d'actuation (420), une électrode fixe de contact (430) et une électrode mobile (410), l'actuateur comprenant en outre un empilement de couches (200), l'électrode mobile (410) comprenant une partie d'ancrage (412) solidaire de l'empilement de couches (200) et une partie mobile (413) configurée pour présenter une position de repos et une position de contact, la position de repos correspondant à une absence de contact entre la partie mobile (413) de l'électrode mobile (410) et l'électrode fixe de contact (430), la position de contact correspondant à un contact entre la partie mobile (413) de l'électrode mobile (410) et l'électrode fixe de contact (430) lorsqu'une polarisation non nulle est appliquée entre l'électrode mobile (410) et l'électrode fixe d'actuation (420), ledit procédé (1000) comprenant les étapes suivantes :
• Fourniture (1010) d'un empilement primaire de couches (100) comprenant :
i. Un premier substrat (110) ;
ii.Une couche monocristalline (120) disposée sur une surface supérieure du premier substrat (110) ;
iii. Une couche intercalaire (411) disposée sur une surface supérieure de la couche monocristalline (120) ;
iv. Une couche de gravure (130) disposée sur une surface supérieure de la couche intercalaire (411) ;
• Fourniture (1020) d'un empilement secondaire de couches (200) comprenant :
i. Un deuxième substrat (211) ;
ii.Une couche de report (212) disposée sur une surface supérieure du deuxième substrat (211) ;
• Formation (1030) par gravure dans la couche de gravure (130) d'au moins trois plots (131, 132, 133), sélectivement à la couche intercalaire (411);
• Encapsulation (1040) des trois plots (131, 132, 133) par une première couche d'encapsulation (140) ;
• Assemblage (1060) de l'empilement primaire de couches (100) avec l'empilement secondaire de couches (200) par collage d'une partie au moins de la surface exposée (141) de la première couche d'encapsulation (140) avec une partie au moins de la surface exposée (213) de la couche de report (212) de sorte à former une interface de collage (214) ;
• Retrait (1070) du premier substrat (110) ;
• Formation (1080) par gravure de la partie d'ancrage (412) et de la partie mobile (413) de l'électrode mobile (410) dans la couche monocristalline (120) ;
• Retrait (1100) d'une partie sacrificielle (414) de la couche intercalaire configuré pour libérer la partie mobile (413) de l'électrode mobile (410) et de sorte à préserver une partie de la couche intercalaire (411) entre la partie d'ancrage (412) de l'électrode mobile (410) et une partie au moins d'un des trois plots (131, 132, 133) ;

2. Procédé (1000) selon la revendication précédente dans lequel la couche monocristalline (120) est à base de et/ou comprenant au moins un matériau pris parmi : un semi-conducteur, un conducteur électrique.

3. Procédé (1000) selon l'une quelconque des revendications précédentes dans lequel la couche de gravure (130) est une couche monocristalline.

4. Procédé (1000) selon la revendication précédente dans lequel la structure cristalline de la couche monocristalline (120) est différente de la structure cristalline de la couche de gravure (130).

5. Procédé (1000) selon l'une quelconque des revendications précédentes dans lequel la couche monocristalline (120) et la couche de gravure (130) sont à base du même matériau.

6. Procédé (1000) selon l'une quelconque des revendications précédentes dans lequel la couche de gravure (130) est obtenue par croissance épitaxiale d'un matériau identique au matériau composant la couche monocristalline (120) et à partir de la couche intercalaire (411).

7. Procédé (1000) selon l'une quelconque des revendications précédentes dans lequel la couche intercalaire (411) présente une dimension en épaisseur inférieure ou égale à la dimension en épaisseur de la couche monocristalline (120), les dimensions en épaisseur étant prises selon un axe orthogonal à la dimension d'extension principale des couches considérées.

8. Procédé (1000) selon l'une quelconque des revendications précédentes dans lequel la couche monocristalline (120) est à base de silicium monocristallin, la couche intercalaire (411) est à base de silicium et de germanium et la couche de gravure (130) est à base de silicium.

9. Procédé (1000) selon l'une quelconque des revendications précédentes dans lequel le collage est un collage moléculaire.

10. Procédé (1000) selon l'une quelconque des revendications précédentes comprenant, avant l'étape d'assemblage (1060), une étape de planarisation (1050) de la surface exposée (141) de la première couche d'encapsulation (140) de sorte à exposer en partie au moins une surface d'au moins un des trois plots (131, 132, 133) et dans lequel l'interface de collage (214) est formée en partie au moins d'une portion de la surface d'un des trois plots (131, 132, 133), d'une partie au moins de la surface exposée (141) de la première couche d'encapsulation (140) et d'une partie au moins de la surface exposée (213) de la couche de report (212).

11. Procédé (1000) selon l'une quelconque des revendications précédentes dans lequel l'étape de retrait (1100) d'une partie de la couche intercalaire (411) comprend au moins une gravure humide ou anhydre configurée pour retirer une partie sacrificielle (414) de la couche intercalaire (411) supportant la partie mobile (413) de l'électrode mobile (410).

12. Procédé (1000) selon l'une quelconque des revendications précédentes comprenant une étape de formation (1110) d'au moins un contact électrique (510, 520, 530) pour chaque plot (131, 132, 133).

13. Actuateur (10, 20) comprenant au moins une électrode fixe d'actuation (420), une électrode fixe de contact (430) et une électrode mobile (410), l'actuateur (10, 20) comprenant au moins un empilement de couches (200), l'électrode mobile (410) comprenant au moins une partie d'ancrage (412) solidaire de l'empilement de couches (200) et une partie mobile (413) configurée pour présenter une position de repos et une position de contact, la position de repos correspondant à une absence de contact entre la partie mobile (413) de l'électrode mobile (410) et l'électrode fixe de contact (430), la position de contact correspondant à un contact entre la partie mobile (413) de l'électrode mobile (410) et l'électrode fixe de contact (430) lorsqu'une polarisation non nulle est appliquée entre l'électrode mobile (410) et l'électrode fixe d'actuation (420), ledit actuateur (10, 20) étant tel que l'électrode mobile (410) est formée d'un matériau monocristallin et en ce que la partie d'ancrage (412) est solidaire de l'empilement de couches (200) au travers d'une couche intercalaire (411), la partie mobile (413) de l'électrode mobile (410) est suspendue par la partie d'ancrage (412) de l'électrode mobile (410) au-dessus d'une partie au moins de l'électrode fixe d'actuation (420) en position de repos, et l'actuateur étant **caractérisé en ce que** la distance séparant la partie mobile (413) et la partie de l'électrode fixe d'actuation (420) est inférieure à 20nm en position de repos.

14. Actuateur (10, 20) selon la revendication précédente comprenant au moins une interface de collage (214) issue du collage d'un empilement primaire de couches (100) avec un empilement secondaire de couches (200).

15. Actuateur (10, 20) selon l'une des deux revendications précédentes, dans lequel la distance séparant la partie mobile (413) et la partie de l'électrode fixe d'actuation (420) est inférieure à 15nm, et avantageusement égale à 12nm, en position de repos.

## Patentansprüche

1. Verfahren (1000) zum Herstellen eines elektromechanischen Aktuators (10, 20), vorzugsweise nanometrisch, umfassend eine feste Betätigungselektrode (420), eine feste Kontaktelektrode (430) und eine bewegliche Elektrode (410), wobei der Aktuator ferner einen Schichtstapel (200) umfasst, wobei die bewegliche Elektrode (410) einen Verankerungsteil (412), der fest mit dem Schichtstapel (200) verbunden ist, und einen beweglichen Teil (413) umfasst, der so eingerichtet ist, dass er eine Ruheposition und eine Kontaktposition aufweist, wobei die Ruheposition einem fehlenden Kontakt zwischen dem beweglichen Teil (413) der beweglichen Elektrode (410) und der festen Kontaktelektrode (430) entspricht, wobei die Kontaktposition einem Kontakt zwischen dem beweglichen Teil (413) der beweglichen Elektrode (410) und der festen Kontaktelektrode (430) entspricht, wenn eine nicht nullpolige Polarisation zwischen der beweglichen Elektrode (410) und der festen Betätigungselektrode (420) angewendet wird, wobei das Verfahren (1000) die folgenden Schritte umfasst:
• Bereitstellen (1010) eines primären Schichtstapels (100), umfassend:
i. ein erstes Substrat (110);
ii. eine monokristalline Schicht (120), die auf einer oberen Oberfläche des ersten Substrats (110) angeordnet ist;
iii. eine Zwischenschicht (411), die auf einer oberen Oberfläche der monokristallinen Schicht (120) angeordnet ist;
iv. eine Ätzschicht (130), die auf einer Oberfläche der Zwischenschicht (411) angeordnet ist;
• Bereitstellen (1020) eines sekundären Schichtstapels (200), umfassend:
i. ein zweites Substrat (211);
ii. eine Überzugsschicht (212), die auf einer oberen Oberfläche des zweiten Substrats (211) angeordnet ist;
• Bildung (1030) durch Ätzen in der Ätzschicht (130) von mindestens drei Stiften (131, 132, 133), wahlweise an der Zwischenschicht (411);
• Einkapselung (1040) der drei Stifte (131, 132, 133) durch eine erste Einkapselungsschicht (140);
• Zusammenfügen (1060) des primären Schichtstapels (100) mit dem sekundären Schichtstapel (200) durch Verkleben mindestens eines Teils der freiliegenden Oberfläche (141) der ersten Einkapselungsschicht (140) mit mindestens einem Teil der freiliegenden Oberfläche (213) der Überzugsschicht (212), so dass eine Klebeschnittstelle (214) gebildet wird;
• Entfernen (1070) des ersten Substrats (110);
• Bilden (1080) durch Ätzen des Verankerungsteils (412) und des beweglichen Teils (413) der beweglichen Elektrode (410) in der monokristallinen Schicht (120);
• Entfernen (1100) eines Opferteils (414) der Zwischenschicht, der so eingerichtet ist, dass er den beweglichen Teil (413) der beweglichen Elektrode (410) freigibt und so, dass ein Teil der Zwischenschicht (411) zwischen dem Verankerungsteil (412) der beweglichen Elektrode (410) und einem Teil mindestens eines der drei Stifte (131, 132, 133) erhalten bleibt;

2. Verfahren (1000) nach dem vorhergehenden Anspruch, wobei die monokristalline Schicht (120) auf einem Material basiert und/oder mindestens ein Material umfasst, das ausgewählt ist aus: einem Halbleiter, einem elektrischen Leiter.

3. Verfahren (1000) nach einem der vorhergehenden Ansprüche, wobei die Ätzschicht (130) eine monokristalline Schicht ist.

4. Verfahren (1000) nach dem vorhergehenden Anspruch, wobei sich die Kristallstruktur der monokristallinen Schicht (120) von der Kristallstruktur der Ätzschicht (130) unterscheidet.

5. Verfahren (1000) nach einem der vorhergehenden Ansprüche, wobei die monokristalline Schicht (120) und die Ätzschicht (130) auf demselben Material basieren.

6. Verfahren (1000) nach einem der vorhergehenden Ansprüche, wobei die Ätzschicht (130) durch epiaxiales Wachstum eines Materials erhalten wird, das mit dem Material identisch ist, aus dem die monokristalline Schicht (120) besteht, und aus der Zwischenschicht (411).

7. Verfahren (1000) nach einem der vorhergehenden Ansprüche, wobei die Zwischenschicht (411) eine Dicke aufweist, die kleiner oder gleich der Dicke der monokristallinen Schicht (120) ist, wobei die Dicke auf einer Achse gemessen wird, die orthogonal zur Hauptausdehnungsabmessung der betrachteten Schichten ist.

8. Verfahren (1000) nach einem der vorhergehenden Ansprüche, wobei die monokristalline Schicht (120) auf monokristallinem Silizium basiert, die Zwischenschicht (411) auf Silizium und Germanium basiert und die Ätzschicht (130) auf Silizium basiert.

9. Verfahren (1000) nach einem der vorhergehenden Ansprüche, wobei das Verkleben ein molekulares Verkleben ist.

10. Verfahren (1000) nach einem der vorhergehenden Ansprüche, das vor dem Montageschritt (1060) einen Schritt des Planarisierens (1050) der freiliegenden Oberfläche (141) der ersten Einkapselungsschicht (140) umfasst, so dass mindestens eine Oberfläche von mindestens einem der drei Stifte (131, 132, 133) teilweise freigelegt wird, und wobei die Klebeschnittstelle (214) teilweise aus mindestens einem Teil der Oberfläche eines der drei Stifte (131, 132, 133), aus mindestens einem Teil der freiliegenden Oberfläche (141) der ersten Einkapselungsschicht (140) und mindestens einem Teil der freiliegenden Oberfläche (213) der Überzugsschicht (212) gebildet ist.

11. Verfahren (1000) nach einem der vorhergehenden Ansprüche, wobei der Schritt des Entfernens (1100) eines Teils der Zwischenschicht (411) mindestens ein nasses oder wasserfreies Ätzen umfasst, das so eingerichtet ist, dass es einen Opferteil (414) der Zwischenschicht (411) entfernt, der den beweglichen Teil (413) der beweglichen Elektrode (410) trägt.

12. Verfahren (1000) nach einem der vorhergehenden Ansprüche, das einen Schritt (1110) umfasst, bei dem mindestens ein elektrischer Kontakt (510, 520, 530) für jeden Stift (131, 132, 133) gebildet wird.

13. Aktuator (10, 20), umfassend mindestens eine feste Betätigungselektrode (420), eine feste Kontaktelektrode (430) und eine bewegliche Elektrode (410), wobei der Aktuator (10, 20) mindestens einen Schichtstapel (200) umfasst, wobei die bewegliche Elektrode (410) mindestens einen Verankerungsteil (412), der fest mit dem Schichtstapel (200) verbunden ist, und einen beweglichen Teil (413) umfasst, der so eingerichtet ist, dass er eine Ruheposition und eine Kontaktposition aufweist, wobei die Ruheposition einem fehlenden Kontakt zwischen dem beweglichen Teil (413) der beweglichen Elektrode (410) und der festen Kontaktelektrode (430) entspricht, wobei die Kontaktposition einem Kontakt zwischen dem beweglichen Teil (413) der beweglichen Elektrode (410) und der festen Kontaktelektrode (430) entspricht, wenn eine nicht nullpolige Polarisation zwischen der beweglichen Elektrode (410) und der festen Betätigungselektrode (420) angewendet wird, wobei der Aktuator (10, 20) so ist, dass die bewegliche Elektrode (410) aus einem monokristallinen Material gebildet ist und der Verankerungsabschnitt (412) durch eine Zwischenschicht (411) mit dem Schichtenstapel (200) verbunden ist, wobei der bewegliche Teil (413) der beweglichen Elektrode (410) durch den Verankerungsabschnitt (412) der beweglichen Elektrode (410) über mindestens einem Teil der festen Betätigungselektrode (420) in der Ruheposition aufgehängt ist, und wobei der Aktuator **dadurch gekennzeichnet ist, dass** der Abstand zwischen dem beweglichen Teil (413) und dem Teil der festen Betätigungselektrode (420) in der Ruheposition kleiner als 20 nm ist.

14. Aktuator (10, 20) nach dem vorhergehenden Anspruch, der mindestens eine Klebeschnittstelle (214) umfasst, die aus dem Verkleben eines primären Schichtstapels (100) mit einem sekundären Schichtstapel (200) besteht.

15. Aktuator (10, 20) nach einem der beiden vorhergehenden Ansprüche, wobei der Abstand zwischen dem beweglichen Teil (413) und dem Teil der festen Betätigungselektrode (420) in Ruheposition kleiner als 15 nm und vorteilhafterweise gleich 12 nm ist.

## Claims

1. A method (1000) for manufacturing an electromechanical actuator (10, 20), preferably nanometric, comprising a fixed actuation electrode (420), a fixed contact electrode (430) and a movable electrode (410), the actuator further comprising a stack of layers (200), the movable electrode (410) comprising an anchor part (412) integral with the stack of layers (200) and a movable part (413) configured to have a rest position and a contact position, the rest position corresponding to a lack of contact between the movable part (413) of the movable electrode (410) and the fixed contact electrode (430), the contact position corresponding to a contact between the movable part (413) of the movable electrode (410) and the fixed contact electrode (430) when a non-zero polarisation is applied between the movable electrode (410) and the fixed actuation electrode (420), said method (1000) comprising the following steps:
• Providing (1010) a primary stack of layers (100) comprising:
i. A first substrate (110);
ii. A single crystal layer (120) disposed on a top surface of the first substrate (110);
iii. An interlayer (411) disposed on a top surface of the single crystal layer (120);
iv. An etching layer (130) disposed on a top surface of the interlayer (411);
• Providing (1020) a secondary stack of layers (200) comprising:
i. A second substrate (211);
ii. A transfer layer (212) disposed on a top surface of the second substrate (211);
• Forming (1030) at least three pads (131, 132, 133), by etching in the etching layer (130), selectively to the interlayer (411);
• Encapsulating (1040) the three pads (131, 132, 133) by a first encapsulation layer (140);
• Assembling (1060) the primary stack of layers (100) with the secondary stack of layers (200) by bonding at least part of the exposed surface (141) of the first encapsulation layer (140) with at least part of the exposed surface (213) of the transfer layer (212) so as to form a bonding interface (214);
• Removing (1070) the first substrate (110);
• Forming (1080) the anchor part (412) and the movable part (413) of the movable electrode (410) by etching into the single crystal layer (120);
• Removing (1100) a sacrificial part (414) of the interlayer configured to release the movable part (413) of the movable electrode (410) and so as to keep part of the interlayer (411) between the anchor part (412) of the movable electrode (410) and at least part of one of the three pads (131, 132, 133);

2. The method (1000) according to the preceding claim, wherein the single crystal layer (120) is based on and/or comprises at least one material chosen from: a semiconductor, an electrical conductor.

3. The method (1000) according to any of the preceding claims, wherein the etching layer (130) is a single crystal layer.

4. The method (1000) according to the preceding claim, wherein the crystal structure of the single crystal layer (120) is different from the crystal structure of the etching layer (130).

5. The method (1000) according to any of the preceding claims, wherein the single crystal layer (120) and the etching layer (130) are based on the same material.

6. The method (1000) according to any of the preceding claims, wherein the etching layer (130) is obtained by epitaxially growing a material identical to the material making up the single crystal layer (120) and from the interlayer (411).

7. The method (1000) according to any of the preceding claims, wherein the interlayer (411) has a thickness dimension less than or equal to the thickness dimension of the single crystal layer (120), the thickness dimensions being taken along an axis orthogonal to the main dimension of extension of the layers considered.

8. The method (1000) according to any of the preceding claims, wherein the single crystal layer (120) is based on single crystal silicon, the interlayer (411) is based on silicon and germanium and the etching layer (130) is based on silicon.

9. The method (1000) according to any of the preceding claims, wherein bonding is molecular bonding.

10. The method (1000) according to any of the preceding claims, comprising, before the assembly step (1060), a step of planarising (1050) the exposed surface (141) of the first encapsulation layer (140) so as to at least partly expose a surface of at least one of the three pads (131, 132, 133) and wherein the bonding interface (214) is at least partly formed of the surface of one of the three pads (131, 132, 133), of at least part of the exposed surface (141) of the first encapsulation layer (140) and at least part of the exposed surface (213) of the transfer layer (212).

11. The method (1000) according to any of the preceding claims, wherein the step of removing (1100) part of the interlayer (411) comprises at least one wet or anhydrous etching configured to remove a sacrificial part (414) from the interlayer (411) supporting the movable part (413) of the movable electrode (410).

12. The method (1000) according to any of the preceding claims, comprising a step of forming (1110) at least one electrical contact (510, 520, 530) for each pad (131, 132, 133).

13. An actuator (10, 20) comprising at least a fixed actuation electrode (420), a fixed contact electrode (430) and a movable electrode (410), the actuator (10, 20) comprising at least a stack of layers (200), the movable electrode (410) comprising at least an anchor part (412) integral with the stack of layers (200) and a movable part (413) configured to have a rest position and a contact position, the rest position corresponding to a lack of contact between the movable part (413) of the movable electrode (410) and the fixed contact electrode (430), the contact position corresponding to a contact between the movable part (413) of the movable electrode (410) and the fixed contact electrode (430) when a non-zero polarisation is applied between the movable electrode (410) and the fixed actuation electrode (420), said actuator (10, 20) being such that the movable electrode (410) is formed of a single crystal material and in that the anchor part (412) is integral with the stack of layers (200) through an interlayer (411), the movable part (413) of the movable electrode (410) is suspended by the anchor part (412) of the movable electrode (410) above at least one part of the fixed actuation electrode (420) in the rest position, and the actuator being **characterised in that** the distance separating the movable part (413) and the part of the fixed actuation electrode (420) is less than 20nm in the rest position.

14. The actuator (10, 20) according to the preceding claim, comprising at least one bonding interface (214) derived from bonding a primary stack of layers (100) with a secondary stack of layers (200).

15. The actuator (10, 20) according to one of the two preceding claims, wherein the distance separating the movable part (413) and the part of the fixed actuation electrode (420) is less than 15nm, and advantageously equal to 12nm, in the rest position.
